# EUROPEAN PATENT APPLICATION

(11) **EP 4 199 097 A1**
(43) Date of publication of application: **21.06.2023**
(21) Application number: 21863584.5
(22) Date of filing: 30.08.2021
(51) Int. Cl.: H01L 27/32

(54) **DISPLAY PANEL AND TERMINAL DEVICE**

(30) Priority: 02.09.2020 CN 202010909030
(71) Applicant: Huawei Technologies Co., Ltd., Shenzhen, Guangdong 518129 (CN)
(72) Inventor: ZHANG, Wenlin, Shenzhen, Guangdong 518129 (CN); WANG, Liying, Shenzhen, Guangdong 518129 (CN); WANG, Qiang, Shenzhen, Guangdong 518129 (CN); LEE, Mengting, Shenzhen, Guangdong 518129 (CN); LI, Xiuling, Shenzhen, Guangdong 518129 (CN)
(74) Representative: Maiwald GmbH
(86) International application number: PCT/CN2021/115425
(87) International publication number: WO 2022/048519

(57) **Abstract**

This application provides a display panel and a terminal device. The display panel is provided with an effective display region, a hole-punch region located in the effective display region, and a border region surrounding the hole-punch region. The effective display region is provided with a plurality of first traces extending in a first direction, and second traces extending in a second direction, where the first direction is perpendicular to the second direction. In at least a portion of the first traces whose extension directions pass through the hole-punch region, portions of each first trace respectively arranged on two sides of the hole-punch region are connected by one of first windings, to ensure that the portions of the first trace respectively arranged on the two sides of the hole-punch region are connected, and at least a portion of the first windings are located in the effective display region, thereby reducing the area of the border region occupied by the first windings; and/or in at least a portion of the second traces whose extension directions pass through the hole-punch region, portions of each second trace respectively arranged on the two sides of the hole-punch region are connected by one of second windings, and at least a portion of the second windings are located in the effective display region, thereby reducing the area of the border region.

## Description

### CROSS-REFERENCE TO RELATED APPLICATIONS

This application claims priority to Chinese Patent Application No. 202010909030.X, filed with the China National Intellectual Property Administration on September 2, 2020 and entitled "DISPLAY PANEL AND TERMINAL DEVICE", which is incorporated herein by reference in its entirety.

### TECHNICAL FIELD

This application relates to the field of display technologies, and in particular, to a display panel and a terminal device.

### BACKGROUND

As users have growing requirements on screen-to-body ratios of terminal devices such as mobile phones and the design of front-facing cameras is taken into account, there are products in the market, such as infinity-U displays, hole-punch displays, and notch screens, having screen-to-body ratios close to those of bezel-less screens.

A hole-punch screen such as an active-matrix organic light-emitting diode (AMOLED) screen provides space for arrangement of a front-facing camera by disposing a hole in an effective display region (active area) of a display panel.

However, packaging is usually performed around the hole-punch region to form a packaging region, so as to avoid adverse effects such as dark spots caused by failure of a material in a panel due to water and oxygen, prevent cracks during drilling, and reduce thermal effect on the panel material. In addition, both transverse traces and longitudinal traces are wound around the packaging region to form a winding region, so as to connect the transverse traces passing through the hole-punch region and to connect the longitudinal traces, where content cannot be displayed in the packaging region and the winding region. As a result, a black border region (border area) is generated around the hole-punch region. When the area of the border region is relatively large, display effect is affected, resulting in poor user experience.

### SUMMARY

This application provides a display panel and a terminal device, to reduce the area of a border region around a hole-punch region, so as to improve user experience.

According to a first aspect, a display panel is provided. The display panel is provided with an effective display region, a hole-punch region located in the effective display region, and a border region surrounding the hole-punch region. The effective display region is provided with a plurality of first traces extending in a first direction, and second traces extending in a second direction, where the first direction is perpendicular to the second direction. In at least a portion of the first traces whose extension directions pass through the hole-punch region, portions of each first trace respectively arranged on two sides of the hole-punch region are connected by one of first windings, so as to ensure that the portions of the first traces respectively arranged on the two sides of the hole-punch region are connected, and at least a portion of the first windings are located in the effective display region, to reduce the area of the border region occupied by the first windings, thereby reducing the area of the border region; and/or in at least a portion of the second traces whose extension directions pass through the hole-punch region, portions of each second trace respectively arranged on two sides of the hole-punch region are connected by one of second windings, and at least a part of the second windings are located in the effective display region, to reduce the area of the border region occupied by the second windings, thereby achieving effect of reducing the area of the border region.

To further reduce the area of the border region, in a specific implementable solution, each first winding is located in the effective display region, and/or each second winding is located in the effective display region.

There may be a plurality of forms of the first winding, provided that the first winding can bypass the hole-punch region. In a specific implementable solution, each first winding includes a first segment, a second segment, and a third segment. The first segment extends in the first direction, and both the second segment and the third segment extend in the second direction. In each group of first trace and the first winding that correspond to each other, one end of the second segment is connected to a portion that is of the first trace and is located on one side of the hole-punch region. One end of the third segment is connected to a portion that is of the first trace and that is located on the other side of the hole-punch region. The other end of the second segment is connected to the other end of the third segment by the first segment. On the premise of ensuring that the first winding can bypass the hole-punch region, a short circuit probability of a metal trace is reduced.

In a specific implementable solution, in each of the first windings, the first segment, the second segment, and the third segment each are disposed hierarchically with respect to a corresponding first trace, to simplify wiring complexity of each layer of metal traces and reduce a short circuit probability.

In a more specific implementable solution, the second segment and the third segment each are disposed hierarchically with respect to the first segment, so that segments of the first winding are distributed in different metal layers, to further reduce a short circuit probability in a same metal layer.

To reduce a parasitic capacitance increased due to arrangement of the first winding, and reduce signal capacitance crosstalk, a portion of the first traces are signal wires. In at least a portion of signal wires, one first segment is disposed on at least one side of the second direction of each signal wire, and/or the signal wire and one first segment are stacked.

Similar to the first winding, the second winding may also have various forms. Each of the second windings includes a fourth segment, a fifth segment, and a sixth segment. The fourth segment extends in the second direction, and both the fifth segment and the sixth segment extend in the first direction. In each group of second trace and second winding that correspond to each other, one end of the fifth segment is connected to a portion that is of the second trace and that is located on one side of the hole-punch region. One end of the sixth segment is connected to a portion that is of the second trace and that is located on the other side of the hole-punch region. The other end of the fifth segment is connected to the other end of the sixth segment by the fourth segment. On the premise of ensuring that the first winding can bypass the hole-punch region, a short circuit probability of a metal trace is reduced.

In a specific implementable solution, in each of the second windings, the fourth segment, the fifth segment, and the sixth segment each are disposed hierarchically with respect to a corresponding second trace, to simplify wiring complexity of each layer of metal traces and reduce a short circuit probability.

In a specific implementable solution, in each of the second windings, the fifth segment and the sixth segment each are disposed hierarchically with respect to the fourth segment. Therefore, the segments of the second winding are distributed in different metal layers, to further reduce a short circuit probability in a same metal layer.

In a specific implementable solution, an average resistance value per unit length of the first winding is lower than an average resistance value per unit length of the corresponding first trace; and/or an average resistance value per unit length of the second winding is lower than an average resistance value per unit length of the corresponding second trace, to reduce a parasitic capacitance additionally increased due to winding.

In addition to using a winding manner, to reduce the area of a border region, some traces may alternatively be directly disconnected. For example, in a specific implementable solution, in at least a portion of the first traces whose extension directions pass through the hole-punch region, portions of each of first trace respectively arranged on the two sides of the hole-punch region are disconnected; and/or in at least a portion of the second traces whose extension directions pass through the hole-punch region, the portions of each second trace respectively arranged on the two sides of the hole-punch region are disconnected. This can simplify line distribution in the effective display region.

In a specific implementable solution, a portion of the first traces are light emitting signal wires, and two portions that are respectively arranged on the two sides of the hole-punch region and that are of a light emitting signal wire whose extension direction passes through the hole-punch region are disconnected; and/or a portion of the first traces are scanning lines, two portions that are respectively arranged on the two sides of the hole-punch region and that are of a scanning line whose extension direction passes through the hole-punch region are disconnected, and lengths of the portions of the scanning line respectively arranged on two sides of the hole-punch region are equal; and/or a portion of the first traces are initial voltage lines, two portions that are respectively arranged on the two sides of the hole-punch region and that are of an initial voltage line whose extension direction passes through the hole-punch region are disconnected, and lengths of the portions of the initial voltage line respectively arranged on the two sides of the hole-punch region are equal.

In a specific implementable solution, a portion of the second traces are electroluminescent device drain voltage lines, and portions, respectively arranged on the two sides of the hole-punch region, of an electroluminescent device drain voltage line whose extension direction passes through the hole-punch region are disconnected.

According to a second aspect, a terminal device is provided. The terminal device may be a terminal device having a front-facing camera, such as a mobile phone, a tablet computer, or a smartwatch. The terminal device includes a camera and the display panel provided in any one of the foregoing technical solutions. The camera is disposed on a side that is of the display panel and that is away from a light emitting surface, and is configured to receive light passing through the hole-punch region to perform imaging.

Because the terminal device uses the display panel provided in the foregoing technical solution, a border region of the display panel is relatively small, and a black border generated due to the border region around the camera is relatively small, which helps improve aesthetics of the terminal device and improve display effect.

### BRIEF DESCRIPTION OF DRAWINGS

FIG. 1 is a schematic diagram of a partial structure of a display panel;
FIG. 2 shows a display panel according to an embodiment of this application;
FIG. 3a is a partial enlarged view of A in FIG. 2;
FIG. 3b is a schematic diagram showing that one of first traces and one of second traces are arranged crosswise in FIG. 3a;
FIG. 3c is a partial enlarged view of FIG. 3a;
FIG. 4 is a schematic distribution diagram of the first traces in FIG. 3a;
FIG. 5 is a schematic diagram of cooperation between a first trace 1a and a first winding u1 in FIG. 4;
FIG. 6 is a cross-sectional view of a position B-B in FIG. 5;
FIG. 7 is a schematic distribution diagram of the second traces in FIG. 3a;
FIG. 8 is a schematic diagram of cooperation between a second trace 2a and a second winding u2 in FIG. 7;
FIG. 9 is a diagram of a pixel circuit of a pixel unit in the display panel 1 shown in FIG. 2;
FIG. 10 is a line distribution diagram of the pixel circuit shown in FIG. 9;
FIG. 11 shows a specific embodiment of distribution of first windings u1 in the pixel circuit shown in FIG. 10;
FIG. 12 shows another specific embodiment of distribution of first windings u1 in the pixel circuit shown in FIG. 10;
FIG. 13 shows another specific embodiment of distribution of first windings u1 in the pixel circuit shown in FIG. 10;
FIG. 14 shows another specific embodiment of distribution of first windings u1 in the pixel circuit shown in FIG. 10;
FIG. 15 shows a variation of the embodiment shown in FIG. 4;
FIG. 16 is a schematic diagram of cooperation between a first trace 1a and a first winding u1 in FIG. 15;
FIG. 17 shows a variation of the embodiment shown in FIG. 7;
FIG. 18 is a schematic diagram of cooperation between a second trace 2a and a second winding u2 in FIG. 17;
FIG. 19 shows a variation of the embodiment shown in FIG. 17;
FIG. 20 is a schematic diagram of cooperation between a camera 2 and a display panel 1 in a terminal device according to an embodiment of this application; and
FIG. 21 is a schematic diagram of cooperation between a camera 2 and a display panel 1 in another terminal device according to an embodiment of this application.

### DESCRIPTION OF EMBODIMENTS

To make objectives, technical solutions, and advantages of this application clearer, this application is further described below in detail with reference to the accompanying drawings.

To facilitate understanding of a display panel provided in embodiments of this application, an application scenario of the display panel is first described. The display panel may be applied to a terminal device having a front-facing camera, such as a mobile phone, a tablet computer, or a smartwatch, and is configured to output image information. The display panel may be one of an OLED (Chinese name: organic light-emitting diode; English full name: organic light-emitting diode) display screen, a microLED (Chinese name: micro light emitting diode; English full name: micro light emitting diode) display screen, and the like. The OLED display screen may be specifically an AMOLED (Chinese name: active-matrix organic light-emitting diode; English full name: active-matrix organic light-emitting diode) display screen.

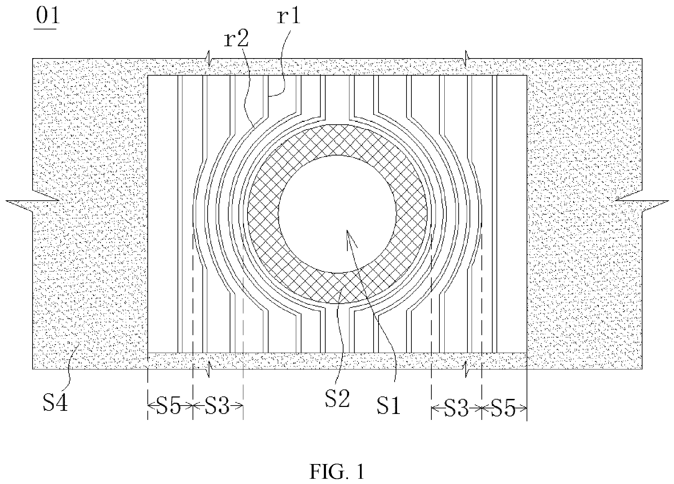

FIG. 1 is a schematic diagram of a partial structure of a display panel. Referring to FIG. 1, a circular hole-punch region S1 is provided in a middle part of a display panel 01 (an AMOLED display screen is used as an example). The hole-punch region S1 forms a camera avoidance hole to transmit light for imaging by a camera. An annular packaging region S2 is formed around the hole-punch region S1, and an isolation column and/or an isolation groove are formed in the packaging region S2 to prevent water and oxygen diffusion. Each longitudinal winding r1 near the packaging region S2 is wound on the left or right side of the hole-punch region S1 by using the windings r2, and the winding r2 is in an arc shape with an opening facing the packaging region S2. The plurality of windings r2 near the packaging region S2 form a first sub-winding region S3 on left and right sides of the packaging region S2. FIG. 1 merely shows a winding status of longitudinal traces r1, and the display panel 01 is further provided with transverse traces (not shown in FIG. 1) that are staggered with the foregoing longitudinal traces. The transverse traces near the packaging region S2 form a second sub-winding region (not shown in FIG. 1, and for the formation manner, refer to the first sub-winding region) on the upper and lower sides of the packaging region. Therefore, the first sub-winding region S3 and the second sub-winding region jointly form a winding region in an entire circumferential direction of the packaging region S2, and an effective display region S4 for displaying a screen is provided around the winding region. A specific dummy region (dummy area) S5 is provided between the winding region and the effective display region S4, and no display device is disposed in the dummy region S5. Due to existence of the winding region, a border region (border area) in which a display device cannot be disposed around the hole-punch region S1 is relatively large, which affects display effect and leads to poor user experience. The border region includes the packaging region S2, the winding region, and the dummy region S5.

To resolve the foregoing technical problem, an embodiment of this application provides a display panel.

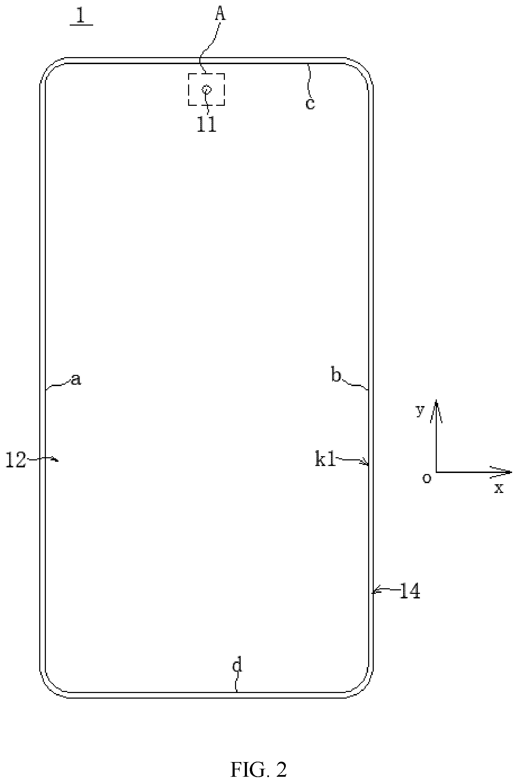

FIG. 2 shows a display panel according to an embodiment of this application. Referring to FIG. 2, an example in which the display panel 1 is applied to a mobile phone is used. The display panel 1 includes an effective display region 12, a peripheral region 14 located at a circumferential edge of the effective display region 12, and a hole-punch region 11 located inside the effective display region 12. The effective display region 12 is used to display a screen, and the peripheral region 14 is a non-display region. An outline of a circumferential outer edge (denoted as a first border k1) of the effective display region 12 is roughly rectangular, and may be specifically a shape obtained after chamfers are formed at four right angles of the rectangle. For example, the first border k1 includes a first side edge a, a second side edge b, a third side edge c, and a fourth side edge d. The first side edge a and the second side edge b are disposed opposite and parallel to each other (for example, which are both parallel to a y-axis). The third side edge c and the fourth side edge d are disposed opposite and parallel to each other (for example, which are both parallel to an x axis). A top end (one end in the positive direction of the y-axis) of the first side edge a and a top end (one end in the positive direction of the y-axis) of the second side edge b are connected by the third side edge c. A bottom end (one end in the negative direction of the y-axis) of the first side edge a and a bottom end (one end in the negative direction of the y-axis) of the second side edge b are connected by the fourth side edge d, and a chamfer is formed between every two adjacent side edges.

The hole-punch region 11 forms a light transmission hole. The light transmission hole may be a through-hole that penetrates the display panel 1 and is formed in the hole-punch region 11, or may be a counterbore formed by etching a film layer of the display panel 1 except a transparent substrate in the hole-punch region 11, provided that it is ensured that the hole-punch region 11 transmits light, so that the camera may perform imaging by using light transmitted through the hole-punch region 11. A manner of forming a light transmission hole in the hole-punch region 11 may be a known and commonly used form, and details are not described herein. The hole-punch region 11 may be circular, or may be in another form such as an ellipse or a regular polygon. An example in which the hole-punch region 11 is circular is used below for description.

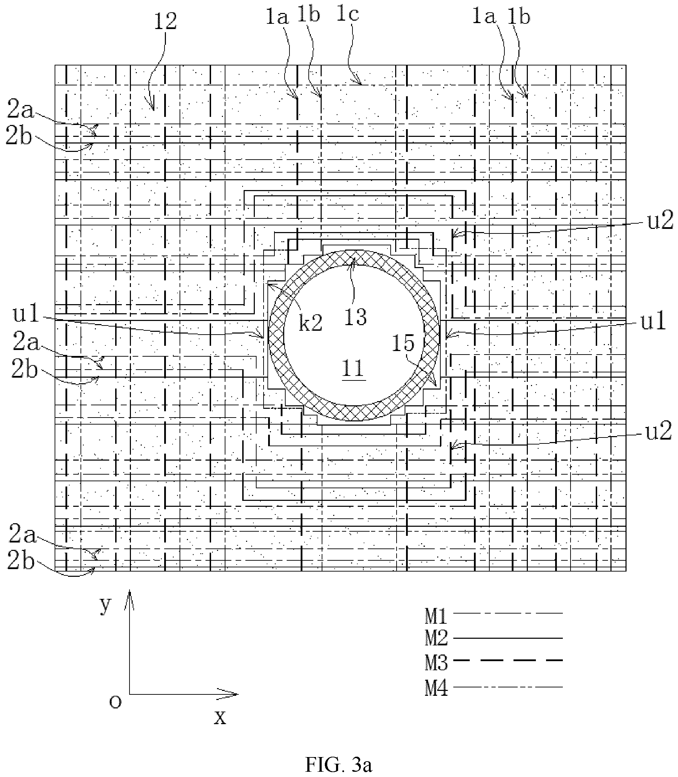

FIG. 3a is a partial enlarged view of a position A in FIG. 2. With reference to FIG. 2 and FIG. 3a, there is an annular packaging region 13 around the hole-punch region 11, and the packaging region 13 is disposed around the hole-punch region 11. In the packaging region 13, an isolation column or an isolation groove that surrounds the hole-punch region 11 is formed on the substrate, or both the isolation column and the isolation groove may be formed. Specifically, the isolation column or the isolation groove may be formed by etching a film layer on the substrate of the display panel 1.

Still referring to FIG. 3a, there is an accommodation region inside the effective display region 12, an edge of the accommodation region is denoted as a second border k2, the packaging region 13 is located in the accommodation region, and a dummy region (dummy region) 15 is formed between an outer edge of the packaging region 13 and the second border k2. No display device is provided on the substrate in the dummy region 15. The enclosed first border k1 and the enclosed second border k2 are used to define the range of the effective display region 12.

Trace distribution in the effective display region 12 is described below.

When the effective display region 12 is formed, a first metal layer M1, a second metal layer M2, a third metal layer M3, and a fourth metal layer M4 are sequentially formed in a direction away from the substrate. Both the first metal layer M1 and the second metal layer M2 may be made of metal Mo, and both the third metal layer M3 and the fourth metal layer M4 may be made of a Ti/Al/Ti stacked structure. The first metal layer M1, the second metal layer M2, the third metal layer M3, and the fourth metal layer M4 are all patterned to form patterns such as metal traces. In addition, one or more insulation layers are formed between the first metal layer M1 and the second metal layer M2, between the second metal layer M2 and the third metal layer M3, and between the third metal layer M3 and the fourth metal layer M4, to electrically isolate metal traces of two adjacent layers, and metal traces formed by different metal layers may be connected by using vias.

Still referring to FIG. 3a, a plurality of first traces (1a and 1b) extending in the first direction (the y-axis direction) and arranged in the second direction (the x-axis direction) and a plurality of second traces (2a and 2b) extending in the second direction (the x-axis direction) and arranged in the first direction (the y-axis direction) are distributed in the effective display region 12. The plurality of first traces (1a and 1b) and the plurality of second traces (2a and 2b) are arranged crosswise to form a plurality of pixel units in array distribution. It should be noted that the first traces (1a and 1b) extend in the first direction, and may extend strictly in the first direction (the y-axis direction), or may have a specific angular error with respect to the first direction, and the angular error may be within a range of ±3°. The second traces (2a and 2b) extend in the second direction (the x-axis direction), and for the meanings of other traces extending in a specific direction, refer to the foregoing description of the first traces (1a and 1b) extending in the first direction. It should be noted that the first direction is the x-axis direction, and the second direction is the y-axis direction, which is merely used to illustrate an example in which the first direction is strictly perpendicular to the second direction. When it is mentioned that the first direction is perpendicular to the second direction, the first direction and the second direction may not be strictly perpendicular, and a specific angular deviation is allowed, for example, an angular deviation of ±3°.

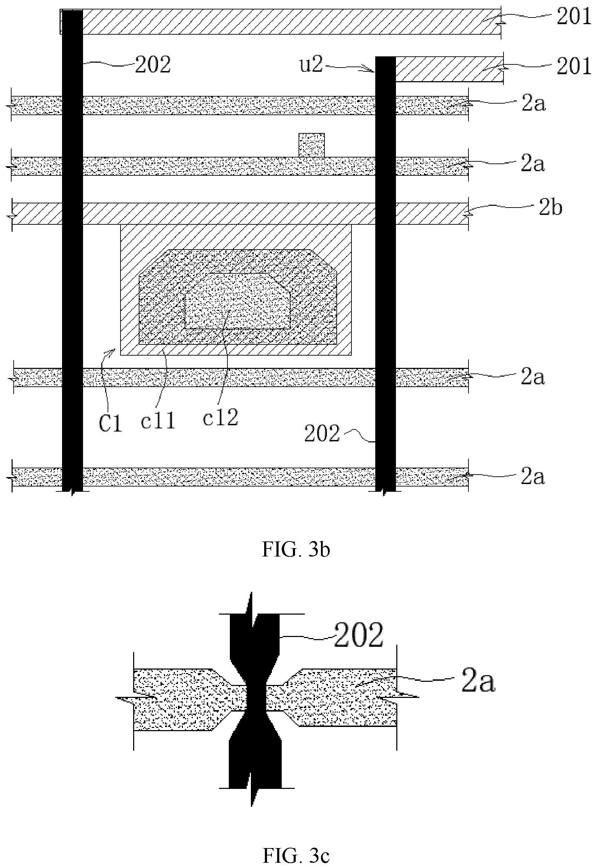

FIG. 3b is a schematic diagram showing that one of first traces and one of second traces are arranged crosswise in FIG. 3a. That the first trace 1a and the second trace 2a are crossed is used as an example. The first trace 1a and the second trace 2a are respectively located at different metal layers. A portion at which the first trace 1a and the second trace 2a cross becomes narrower than the remaining portions on both sides of the portion, and a portion at which the second trace 2a and the first trace 1a cross becomes narrower than other portions at both ends of the crossing portion, so as to reduce a parasitic capacitance between the first trace 1a and the second trace 2a. In addition, two traces extending in a same direction can be staggered to reduce a parasitic capacitance. For example, in FIG. 3a, the first trace 1a and the first trace 1b are arranged at different layers, but are arranged in a staggered manner. An orthographic projection of the first trace 1a on a substrate surface (for example, which is parallel to an xoy plane) and an orthographic projection of the second trace 2b on the substrate surface are staggered to reduce a parasitic capacitance.

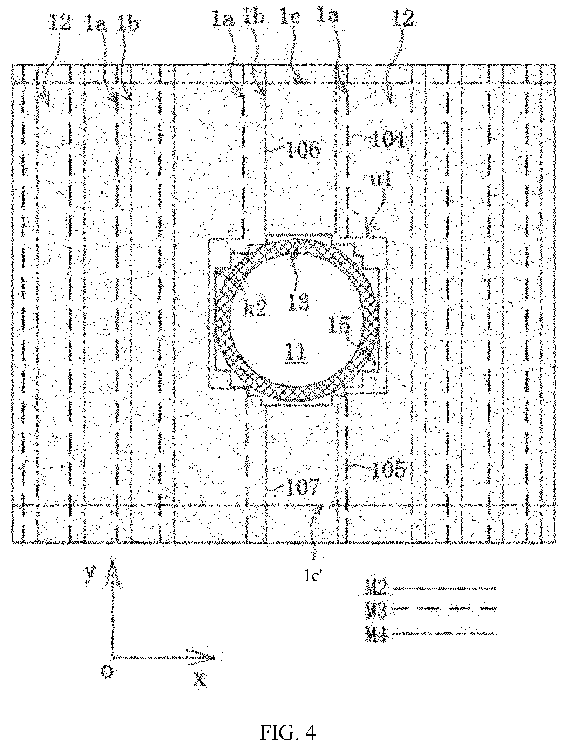

FIG. 3c is a partial enlarged view of FIG. 3a, and FIG. 4 is a schematic distribution diagram of the first traces in FIG. 3a. With reference to FIG. 3a, FIG. 3c, and FIG. 4, an extension direction of a portion of the first traces (1a and 1b) passes through an accommodation region enclosed by the second border k2, or straight lines on which the portion of the first traces (1a and 1b) are located pass through an accommodation region enclosed by the second border k2 and is interrupted at the second border k2. Two segments of each first trace 1a located on two sides of the accommodation region enclosed by the second border k2 are connected by a first winding u1. It should be understood that the straight lines on which a portion of the first traces (1a and 1b) are located herein does not mean that the first traces (1a and 1b) extend strictly along a straight line and may be bent to a specific extent, but extend in a substantially straight line in an overall extension trend. Similar cases below are understood in a similar way, and details are not described again.

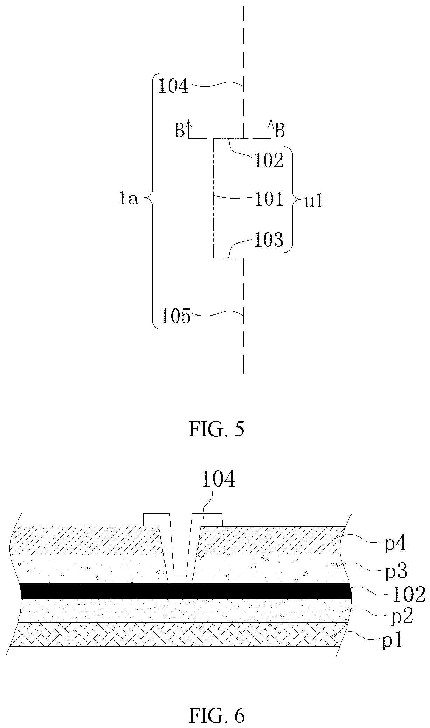

FIG. 5 is a schematic diagram of cooperation between a first trace 1a and a first winding u1 in FIG. 4. With reference to FIG. 4 and FIG. 5, a first trace 1a in FIG. 4 whose extension direction passes through an accommodation region enclosed by a second border k2 is used as an example. The first trace 1a includes a sub-segment 104 and a sub-segment 105. The sub-segment 104 and the sub-segment 105 are on a same straight line and are separated by a second border k2, the sub-segment 104 is located on one side of the hole-punch region 11, and the sub-segment 105 is located on the other side of the hole-punch region 11. The first winding u1 includes a first segment 101, a second segment 102, and a third segment 103, where the first segment 101 extends in a first direction (y-axis direction), and the second segment 102 and the third segment 103 are parallel to each other and both extend in a second direction (x-axis direction). One end in the negative direction of the x-axis of the second segment 102 is connected to one end in the negative direction of the y-axis of the sub-segment 104, and one end in the negative direction of the x-axis of the third segment 103 is connected to one end in the positive direction of the y-axis of the sub-segment 105. One end in the positive direction of the y-axis of the first segment 101 is connected to one end in the positive direction of the x-axis of the second segment 102, and one end in the negative direction of the y-axis of the first segment 101 is connected to one end in the positive direction of the x-axis of the third segment 103. The second segment 102, the first segment 101, and the third segment 103 are successively connected to form a U-shaped structure, and an opening direction of the U-shaped structure faces the hole-punch region 11. The second segment 102, the first segment 101, and the third segment 103 of the first winding u1 are all located inside the effective display region 12 without occupying space in the accommodation region enclosed by the second border k2. An area of a border region (border area) formed between the second border k2 and an edge of the hole-punch region 11 is relatively small, which helps improve display quality of the display panel 1 and improve user experience. The second segment 102, the first segment 101, and the third segment 103 all extend in the first direction or the second direction, which helps to regularly arrange metal traces, avoid crossover between metal traces at a same layer, and improve arrangement density of metal traces. It should be noted that each of the foregoing first windings u1 located inside the effective display region 12 is merely an example. When only a portion of the first windings u1 are located inside the effective display region 12, the other first windings u1 are located inside the border region. This can also reduce the area of the border region to some extent when compared with all the first windings u1 located inside the border region.

For example, each first trace 1a is disposed adjacent to one first trace 1b, and the first trace 1b forms an electroluminescent device drain voltage (English full name: electroluminescent voltage drain device; ELVDD for short) line in the pixel circuit. Lines on which a portion of the first traces 1b are located passes through the accommodation region enclosed by the second border k2, and are disconnected by the second border k2 to form a sub-segment 106 and a sub-segment 107, and the two portions, disconnected by the second border k2, of the first trace 1b are disconnected, and are not connected by winding or the like. The display panel 1 further includes transverse connecting lines (1c and 1c') arranged on two sides of the hole-punch region 11. The transverse connecting line 1c sequentially connects all the first traces 1b in a second direction (the x-axis direction), and connects the sub-segment 106 to other continuous (not disconnected) first traces 1b, so that the sub-segment 106 has the same potential as the other not disconnected first traces 1b. The transverse connecting line 1c' sequentially connects each of the first traces 1b in the second direction (the x-axis direction), and connects the sub-segment 107 to other not disconnected first traces 1b, so that sub-segment 107 has the same potential as other not disconnected first traces 1b, to form equipotential electrodes in different pixel units.

Each first trace 1a belongs to the third metal layer M3, and each first trace 1b, the transverse connecting lines (1c and 1c'), and the first winding u1 all belong to the fourth metal layer M4.

FIG. 6 is a cross-sectional view of a position B-B in FIG. 5, and the cross-sectional view shows a cross-sectional view of a film layer adjacent to the second segment 102 and the sub-segment 104. Referring to FIG. 6, the connection between the second segment 102 and the sub-segment 104 is described as an example. A glass substrate p1 is sequentially provided with an insulation layer p2, a second segment 102, a gate insulation layer (full name: gate insulation; GI for short) p3, and an interlayer dielectric layer (English full name: interlayer dielectric; ILD for short) p4. The insulation layer p2 sequentially includes a polyimide layer (English full name: polyimide; PI for short) in a direction away from the glass substrate p1, a buffer layer (English full name: buffer), and a gate insulation layer. The sub-segment 104 is in contact with and electrically connected to the second segment 102 through a via that penetrates the gate insulation layer p3 and the interlayer dielectric layer p4, to implement electrical connection to the second segment 102. The thickness of the gate insulation layer p3 and the inter layer dielectric layer p4 is about 6000 Å, for example, 5800 Å to 6200 Å. For electrical connection forms of metal traces at different layers in this embodiment of this application, refer to a form in which the second segment 102 and the sub-segment 104 are connected by using a via.

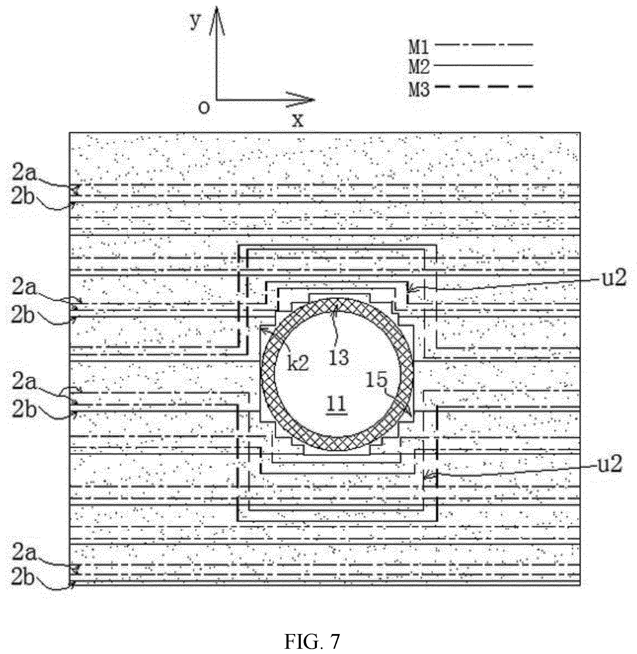

FIG. 7 is a schematic distribution diagram of the second traces in FIG. 3a. With reference to FIG. 3a and FIG. 7, an extension direction of a portion of the second traces (2a and 2b) passes through the accommodation region enclosed by the second border k2, or straight lines on which the portion of the second traces (2a and 2b) are located pass through the accommodation region enclosed by the second border k2, and are interrupted at the second border k2, and two segments of each second trace 2a located on two sides of the accommodation region enclosed by the second border k2 are connected by the second winding u2.

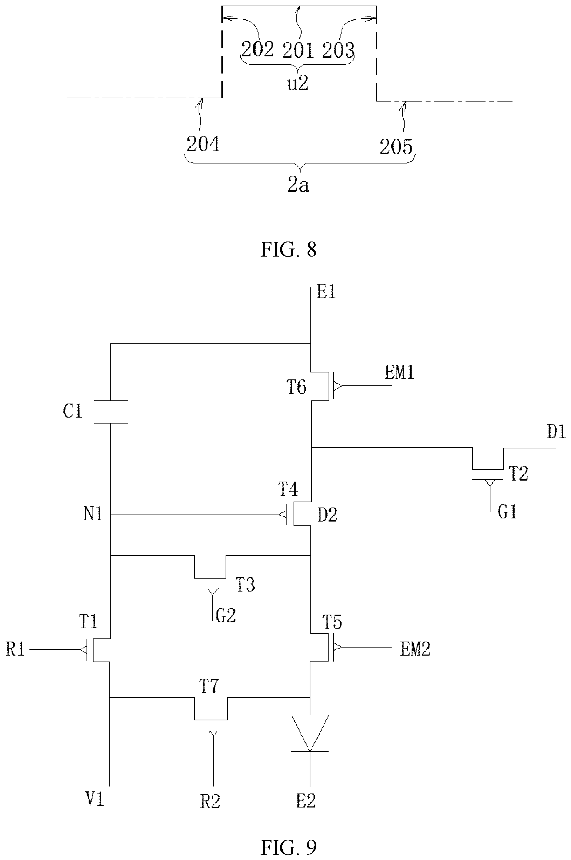

FIG. 8 is a schematic diagram of cooperation between a second trace 2a and a second winding u2 in FIG. 7. With reference to FIG. 7 and FIG. 8, a second trace 2a in FIG. 7 whose extension direction passes through an accommodation region enclosed by a second border k2 is used as an example. The second trace 2a includes a sub-segment 204 and a sub-segment 205 extending in a second direction, and the sub-segment 204 and the sub-segment 205 are on a same straight line and are separated and disconnected by the second border k2. The sub-segment 204 is located on one side of the hole-punch region 11, and the sub-segment 205 is located on the other side of the hole-punch region 11. The second winding u2 includes a fourth segment 201, a fifth segment 202, and a sixth segment 203, where the fourth segment 201 extends in the second direction (the x-axis direction), and the fifth segment 202 and the sixth segment 203 are parallel to each other and both extend in a first direction (the y-axis direction). One end in the negative direction of the y-axis of the fifth segment 202 is connected to one end in the positive direction of the x-axis of the sub-segment 204, and one end in the negative direction of the y-axis of the sixth segment 203 is connected to one end in the negative direction of the x-axis of the sub-segment 205. One end in the negative direction of the x-axis of the fourth segment 201 is connected to one end in the positive direction of the y-axis of the fifth segment 202, and one end in the positive direction of the x-axis of the fourth segment 201 is connected to one end in the positive direction of the y-axis of the sixth segment 203. The fifth segment 202, the fourth segment 201, and the sixth segment 203 are sequentially connected to form a U-shaped structure. In addition, an opening direction of the U-shaped structure faces the hole-punch region 11. For analysis of beneficial effects of the second winding u2, refer to the foregoing related description of the first winding u1. It should be noted that each of the second windings u2 located inside the effective display region 12 is merely an example. When only a portion of the second windings u2 are located inside the effective display region 12, the other second windings u2 are located inside the border region. This can also reduce the area of the border region to some extent when compared with all the second windings u2 located inside the border region.

A first trace 2a is located at a first metal layer M1, a second trace 2b and a fourth segment 201 are both located at the second metal layer M2, and a fifth segment 202 and a sixth segment 203 are both located at a third metal layer M3. Because a resistivity of a material of the third metal layer M3 is less than a resistivity of a material of the first metal layer M1, resistances of the fifth segment 202 and the sixth segment 203 of the trace segments that are increased due to winding are relatively small, so as to avoid, as much as possible, load additionally increased due to winding. In addition, the thickness of the second metal layer M2 and/or the third metal layer M3 may be further increased, or the width of the second metal layer M2 or the third metal layer M3 may be increased, to improve a cross-sectional area of the first winding u1, so as to reduce a resistance per unit length. The foregoing is merely an example, provided that an average resistance value per unit length of the first winding u1 is lower than an average resistance value per unit length of a corresponding first trace. Similarly, an average resistance value per unit length of the second winding section u2 is also lower than an average resistance value per unit length of a corresponding second trace.

For example, a display panel 1 includes a plurality of pixel units in array distribution, and each pixel unit forms a pixel circuit by using a first trace, a second trace, a semiconductor trace, another metal trace, and the like that pass through the pixel unit. FIG. 9 is a diagram of pixel circuit of a pixel unit in the display panel 1 shown in FIG. 2. Referring to FIG. 9, the pixel circuit is a known and commonly used 7T1C pixel circuit, and details are not described herein. E1 represents an electroluminescent device drain voltage (English full name: electroluminescent voltage drain device; ELVDD for short) line, and the electroluminescent device drain voltage line may be formed by compounding the third metal layer M3 and the fourth metal layer M4. E2 represents an electroluminescent device source voltage (English full name: electroluminescent voltage source device; ELVSS for short) line, and EM1 and EM2 both represent light emitting signals (English full name: emit; EM for short), and both R1 and R2 indicate RST lines (Chinese name: reset signal wire; English full name: reset line). V1 indicates a Vinit (Chinese name: initial voltage; English name: initial voltage) line. D1 indicates a signal wire (date line), and D2 indicates a DTFT (Chinese name: drive thin film transistor; full name: drive thin film transistor) line. Both G1 and G2 represent scanning lines (English full name: scan line), and C1 represents a Cst capacitor (Chinese name: storage capacitor; English full name: storage capacitor). For a formation manner of the Cst capacitor C1, refer to FIG. 3c. A first metal electrode layer c11 disposed adjacent to and electrically connected to the second trace 2b is formed in a second metal layer M2. A second metal electrode layer c12 disposed opposite to the first metal electrode layer c11 is formed in a first metal layer M1, and the first metal electrode layer c11 and the second metal electrode layer c12 cooperate with each other to form the Cst capacitor C1. T1, T2, T3, T4, T5, T6, and T7 all represent thin-film transistor switches.

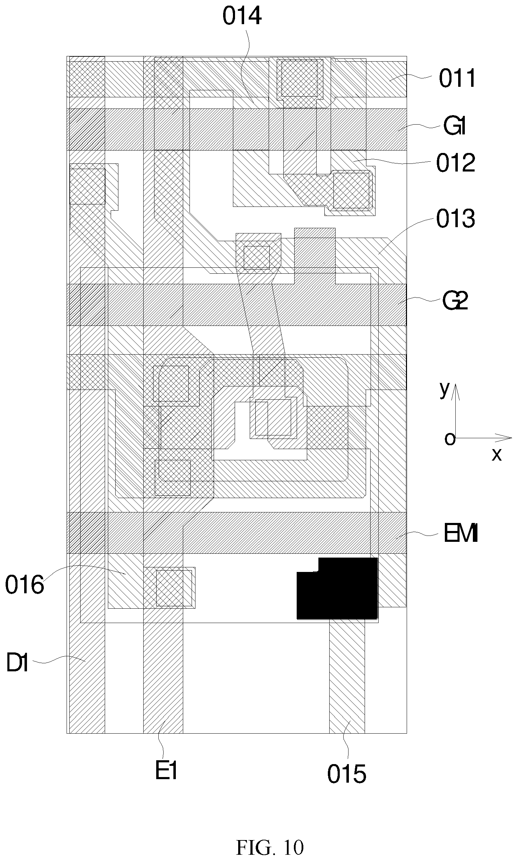

FIG. 10 is a line distribution diagram of the pixel circuit shown in FIG. 9. FIG. 10 merely shows the distribution of a portion of lines in FIG. 9. Reference numerals in FIG. 10 that are the same as those in FIG. 9 indicate same meanings, and 011, 012, 013, 014, 015, and 016 all represent semiconductor traces. It should be noted that a connection relationship between the traces in the pixel circuit may be a known and common connection manner. Still referring to FIG. 10, a signal wire D1 extends in a first direction (y-axis direction), and is located at a position on the left side (a side on the negative direction of an x-axis) of the entire pixel circuit.

The distribution of first windings u1 in the pixel circuit is described below.

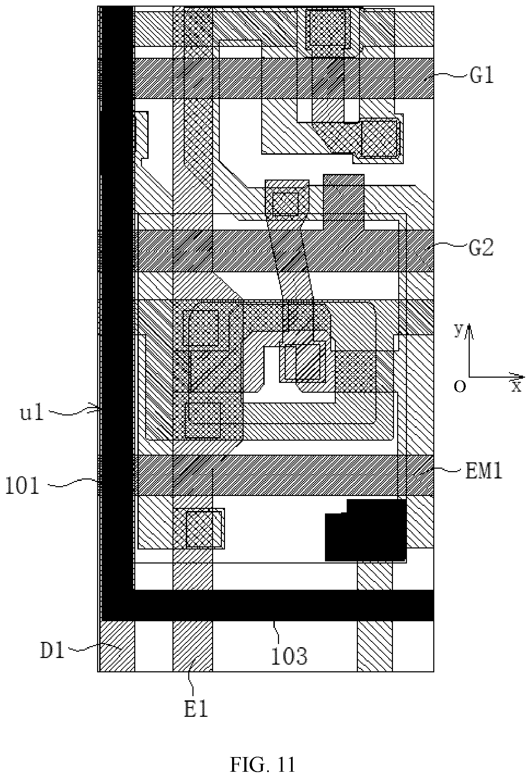

FIG. 11 shows a specific embodiment of distribution of first windings u1 in the pixel circuit shown in FIG. 10. Referring to FIG. 11, the first segment 101 and the signal wire D1 in the first winding u1 are stacked, that is, the first segment 101 is located on a side that is of the signal wire D1 and that is away from the substrate, or is located on a side that is of the signal wire D1 and that faces the substrate. An orthographic projection of the first segment 101 on a substrate surface may overlap or substantially overlap an orthographic projection of the signal wire D1 on the substrate surface.

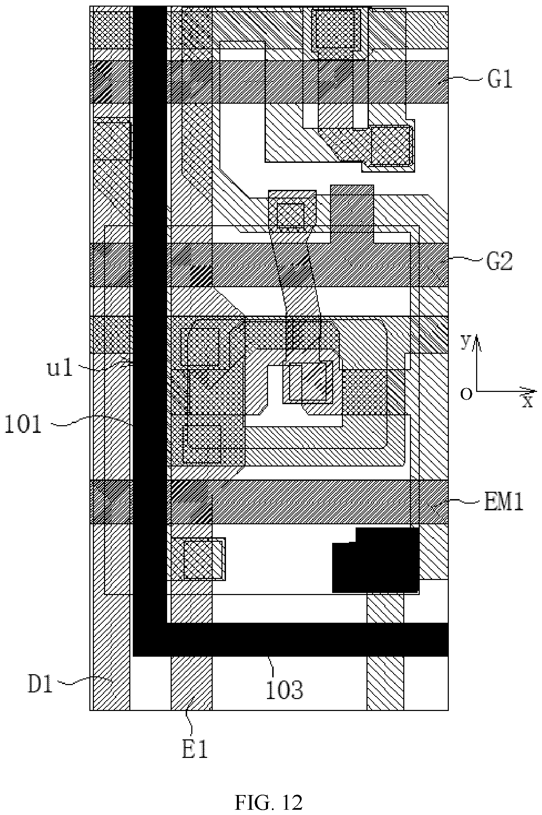

FIG. 12 shows another specific embodiment of distribution of first windings u1 in the pixel circuit shown in FIG. 10. Referring to FIG. 12, an orthographic projection of a first segment 101 in the first winding u1 on a substrate is located between an orthographic projection of the signal wire D1 on the substrate and an orthographic projection of the electroluminescent device drain voltage line E1 on the substrate surface. This can reduce a parasitic capacitance between the first segment 101 and the signal wire D1, and reduce signal crosstalk.

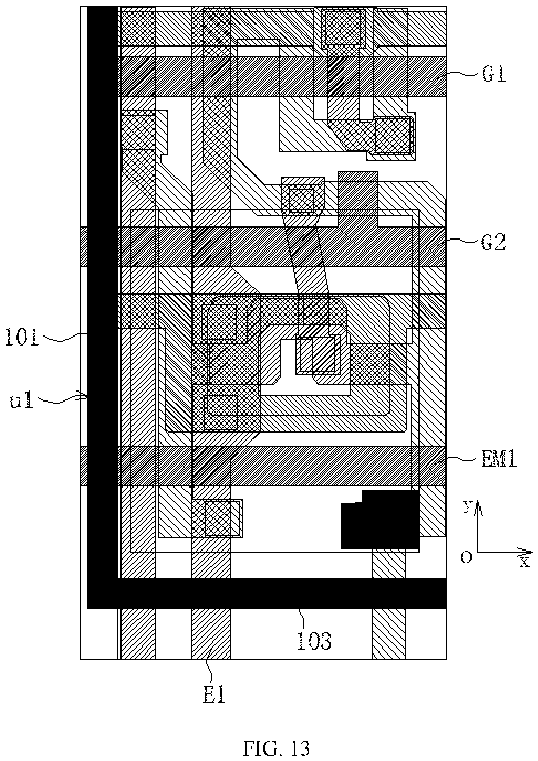

FIG. 13 shows another specific embodiment of distribution of first windings u1 in the pixel circuit shown in FIG. 10. Referring to FIG. 13, an orthographic projection of a first segment 101 in the first winding u1 on a substrate is located on the left side (a side of the negative direction of an x-axis) of an orthographic projection of a signal wire D1 on the substrate. This can reduce a parasitic capacitance between the first segment 101 and the signal wire D1.

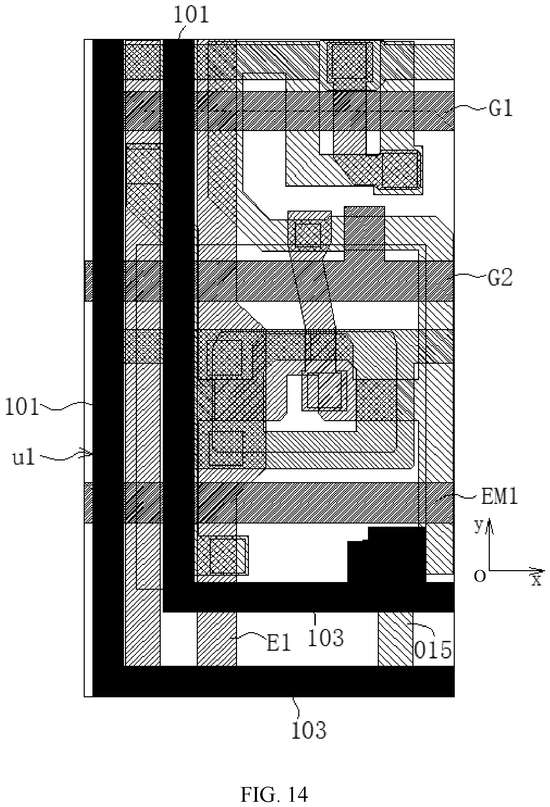

FIG. 14 shows another specific embodiment of distribution of first windings u1 in the pixel circuit shown in FIG. 10. Referring to FIG. 14, an orthographic projection of a first segment 101 in the first winding u1 on a substrate is located between an orthographic projection of a signal wire D1 on the substrate and an orthographic projection of an electroluminescent device drain voltage line E1 on a substrate surface. An orthographic projection of the first segment 101 in another first winding u1 on the substrate is located on the left side (a side of the negative direction of an x-axis) of the orthographic projection of the signal wire D1 on the substrate.

On the basis of FIG. 14, a first winding u1 may be further disposed. A first segment 101 of the first winding u1 and a signal wire D1 are stacked. For the first winding u1, refer to the form in FIG. 11.

Alternatively, two first windings u1 pass through one pixel unit, one first winding u1 uses the winding manner shown in FIG. 12, and the other first winding u1 uses the winding manner shown in FIG. 11. Alternatively, one first winding u1 uses the winding manner shown in FIG. 13, and the other first winding u1 uses the winding manner shown in FIG. 11.

The following analyzes effect of the winding manners in FIG. 12 to FIG. 14 with reference to a simulation experiment. A signal wire D1 (first trace 1a) whose extension passes through the hole-punch region 11 is used as an example for description. Table 1 shows simulation results of the three winding solutions shown in FIG. 12 to FIG. 14.

**Table 1**

| | B1 | | B2 | B3 | B4 | B5 |
|---|---|---|---|---|---|---|
| | B11 | B12 | | | | |
| A1 | 0.754 | 0.461 | 27.931 | 29.146 | 28.540 | 2.1% |
| A2 | 0.754 | 0.383 | 27.931 | 29.068 | 28.540 | 1.8% |
| A3 | 0.623 | 0.464 | 27.931 | 29.018 | 28.540 | 1.7% |

In Table 1, A1 represents the winding solution shown in FIG. 13, A2 represents the winding solution shown in FIG. 12, and A3 represents the winding solution shown in FIG. 14. B1 represents a sum (a sum of B 11 and B12) of parasitic capacitances of the first windings u1 and other traces. B11 represents a sum of parasitic capacitances of the second segment 102 and other traces and parasitic capacitances of the second segment 103 and other traces in the first windings u1. B2 represents a parasitic capacitance generated between the signal wire D1 (excluding the corresponding first winding u1) whose extension direction passes through the hole-punch region 11 and other traces, and B3 represents a sum of B1 and B2. B4 represents a sum of parasitic capacitances generated by a signal wire (first trace 1a) whose extension direction does not pass through the hole-punch region 11 and other traces, and B5 represents a change rate of B3 relative to B4, that is, B5 = (B3 - B4)/B4. In Table 1, units of values corresponding to B11, B12, B2, B3, B4, and B5 are all pF (picofarads).

It can be learned from Table 1 that, the value of B5 in the winding solution A3 corresponding to FIG. 14 is the smallest, and is only 1.7%. This indicates that a parasitic capacitance additionally increased, relative to a case with no winding, in the winding solution A3 has smallest impact.

However, when the signal wire D1 has different gray scale values, that is, when different voltages are applied, a change rate of a current in the signal wire D1 (the first trace 1a) whose extension direction passes through the hole-punch region 11 is also an important reference indicator for selecting a winding solution.

**Table 2**

| | a0 | A1 | | A2 | | A3 | |
|---|---|---|---|---|---|---|---|
| | | a1 | v1 | a2 | v2 | a3 | v3 |
| G255 | 30.8034 | 30.5126 | -0.94% | 30.7093 | -0.31% | 30.5198 | -0.92% |
| (2.7615V) | | | | | | | |
| G143 | 0.752391 | 0.760545 | 1.08% | 0.762283 | 1.31% | 0.742884 | -1.26% |
| (3.7543V) | | | | | | | |
| G127 (3.9V) | 0.38808 | 0.394519 | 1.66% | 0.39649 | 2.17% | 0.383561 | -1.16% |
| G111 | 0.156984 | 0.159852 | 1.83% | 0.160536 | 2.26% | 0.154763 | -1.41% |
| (4.0598V) | | | | | | | |
| G63 (4.6033V) | 0.0081122 | 0.00827153 | 1.96% | 0.00822439 | 1.38% | 0.00810397 | -0.10% |
| G31 | 0.00657093 | 0.00654012 | -0.47% | 0.00663469 | 0.97% | 0.00647615 | -1.44% |
| (5.07949V) | | | | | | | |
| G15 | 0.00642079 | 0.00663934 | 3.4% | 0.00660494 | 2.87% | 0.00655568 | 2.10% |
| (5.429883V) | | | | | | | |

In Table 2, G15, G31, G63, G111, G127, G143, and G255 respectively represent different gray scale values, and a0 represents a current value of a signal wire D1 (first trace 1a) whose extension direction does not passes through the hole-punch region 11. A1 represents the winding solution shown in FIG. 13, a1 represents a current value of a signal wire D1 whose extension direction passes through the hole-punch region 11 in the A1 solution, and v1 represents a change rate of a1 relative to a0, where v1 = (a1 - a0)/a0.

A2 represents the winding solution shown in FIG. 12, a2 represents a current value of a signal wire D1 whose extension direction passes through the hole-punch region 11 in the A2 solution, and v2 represents a change rate of a2 relative to a0, where v2 = (a2 - a0)/a0. A3 represents the winding solution shown in FIG. 14, a3 represents a current value of a signal wire D1 whose extension passes through the hole-punch region 11 in the A3 solution, and v3 represents a change rate of a3 relative to a0, where v3 = (a3 - a0)/a0.

It can be learned from the Table 2 that at a gray scale of G15 and a gray scale of G255, a current change rate of the winding solution A3 is relatively small, and therefore impact of the winding on the current in the signal wire D1 is relatively small. However, at a gray scale of G31, the current change rate of the winding solution A1 is relatively small, and impact of the winding on the current in the signal wire D1 is relatively small. At another gray scale, the current change rate of the winding solution A2 is small, and impact of the winding on the current in the signal wire D1 is relatively small.

In addition, for arrangement positions of a fifth segment 202 and a sixth segment 203 in each second winding u2 relative to the signal wire D1, refer to the wiring manner of the first segment 101 in the first winding u1.

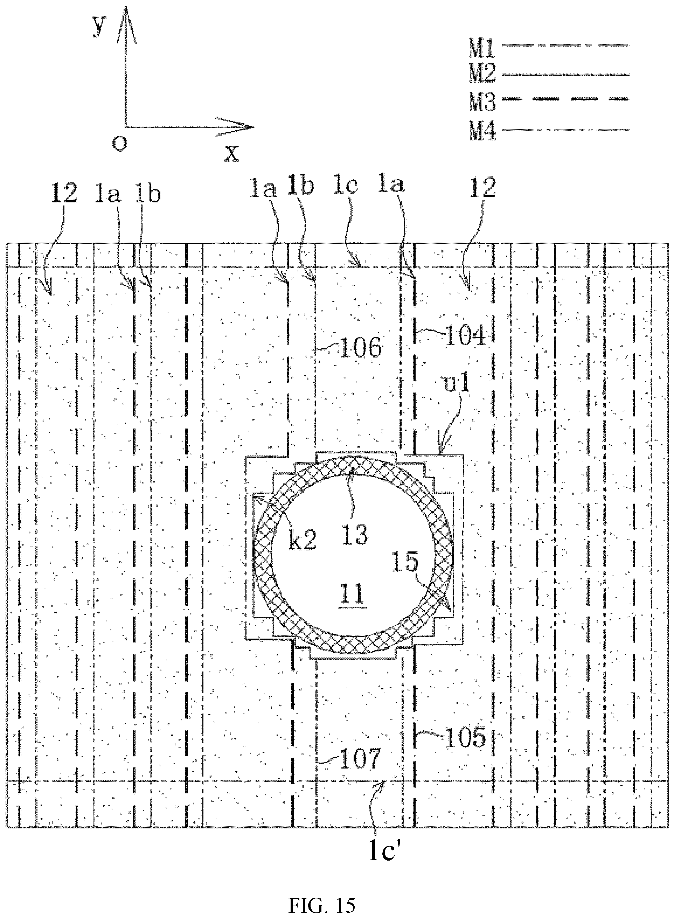

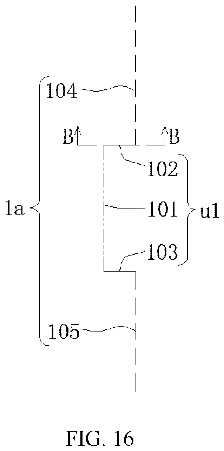

FIG. 15 shows a variation of the embodiment shown in FIG. 4, and FIG. 16 is a schematic diagram of cooperation between a first trace 1a and a first winding u1 in FIG. 15. A difference between FIG. 16 and FIG. 5 lies in that in the first winding u1, both a second segment 102 and a third segment 103 are located at a second metal layer M2, and a first segment 101 is still located at a fourth metal layer M4. The second segment 102 and the third segment 103 are separately electrically connected to the first segment 101 by using a via. Each of the first windings in FIG. 15 is arranged with reference to FIG. 16. In the second metal layer M2, the second segment 102 and the third segment 103 are parallel to each other (a specific angular deviation is allowed for "parallel" herein, for example, within ±3°) and are disconnected to prevent the first segment 101 from interrupting a trace that is in the second metal layer M2 and that is located between the second segment 102 and the third segment 103 and extends in a second direction. This can avoid a cross short circuit when compared with a case in which the first windings u1 are all located at the fourth metal layer M4.

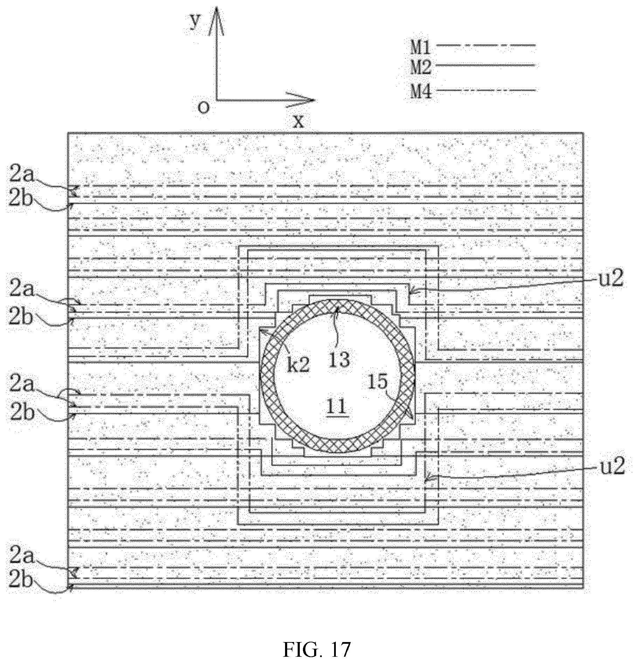

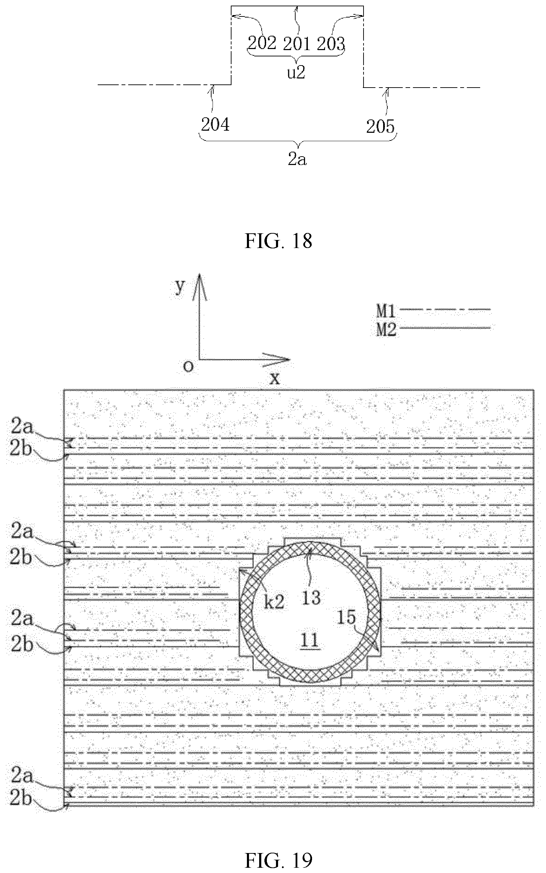

FIG. 17 shows a variation of the embodiment shown in FIG. 7, and FIG. 18 is a schematic diagram of cooperation between a second trace 2a and a second winding u2 in FIG. 17. A difference between FIG. 18 and FIG. 8 lies in that both a fifth segment 202 and a sixth segment 203 are located at a fourth metal layer M4, instead of the third metal layer M3, and the fourth segment 201 is still located at the second metal layer M2.

However, this is merely an example, provided that in each second winding, the fifth segment and the sixth segment are disposed hierarchically with respect to a fourth segment, to help the fourth metal layer M4 avoid a short circuit.

In addition, the fourth segment, the fifth segment, and the sixth segment may alternatively be disposed at a same layer, provided that in each second winding, the fourth segment, the fifth segment, and the sixth segment each are disposed hierarchically with respect to a corresponding second trace, so as to facilitate wiring.

The following analyzes effect of the winding manner in FIG. 15 with reference to a simulation experiment.

**Table 3**

| | B1 | | B2 | B3 | B4 | B5 |
|---|---|---|---|---|---|---|
| | B11 | B12 | | | | |
| A4 | 0.926 | 0.464 | 27.931 | 29.321 | 28.540 | 2.7% |

A form of the first winding u1 shown in FIG. 15 is used as an example. For a winding position of the first winding u1 in a pixel unit, refer to the manner in FIG. 14, which is denoted as a solution A4. Data in Table 3 is obtained by performing a simulation experiment. For meanings of table headers in Table 3 that are the same as those in FIG. 1, refer to the description of Table 1.

It can be learned from Table 3 that the value of B5 (parasitic capacitance change rate) of the solution A4 is 2.7%, which is relatively large when compared with the solutions A1 to A3, but is still feasible.

**Table 4**

| | a0 | A4 | |
|---|---|---|---|
| | | a4 | v4 |
| G255 (2.7615V) | 30.8034 | 30.7433 | -0.19% |
| G143 (3.7543V) | 0.752391 | 0.747387 | 0.668% |
| G127 (3.9V) | 0.38808 | 0.389436 | 0.21% |
| G111 (4.0598V) | 0.156984 | 0.157956 | 0.61% |
| G63 (4.6033V) | 0.0081122 | 0.00872116 | 7.51% |
| G31 (5.07949V) | 0.00657093 | 0.00713529 | 8.59% |
| G15 (5.429883V) | 0.00642079 | 0.00712425 | 10.96% |

In Table 4, a4 represents a current value of a signal wire D1 whose extension direction passes through the hole-punch region 11 in the A4 solution, and v4 represents a change rate of a4 relative to a0, where v4 = (a4 - a0)/a0.

It can be learned from Table 4 that, at a gray scale of G111 to a gray scale of G255, the current change rate in the winding solution A4 is less than 1%, and therefore impact of the winding on the current in the signal wire D1 is relatively small.

The distribution of the first traces shown in FIG. 15 and the distribution of the second traces shown in FIG. 17 may be combined to obtain a diagram having both first trace distribution and second trace distribution.

FIG. 19 shows a variation of the embodiment shown in FIG. 17. Referring to FIG. 19, a difference between the embodiment shown in FIG. 19 and the embodiment shown in FIG. 17 lies in that all first windings u1 are canceled.

Each of the second traces 2a may be a scanning line (refer to G1 and G2 in FIG. 9). In each scanning line disconnected by the hole-punch region 11, the length of a portion located on the left side of the hole-punch region 11 is the same as the length of the portion located on the right side of the hole-punch region 11, to ensure that portions of each scanning line located on two sides of the hole-punch region 11 are separately driven, with a same load size, and a same delay. It should be noted that, lengths of portions of the scanning line located on different sides of the hole-punch region 11 may be the same in a strict sense, or a specific error may exist. The error may be within 5% of a shorter portion of the scanning line. A similar understanding is provided for the lengths of the portions that are of other traces and that are distributed on two sides of the hole-punch region 11 in the following description. Moreover/alternatively, the second trace 2a may be a light emitting signal wire (refer to E1 and E2 in FIG. 9), and in a light emitting signal wire disconnected at the hole-punch region 11, the length of a portion located on the left side of the hole-punch region 11 and the length of a portion located on the right side of the hole-punch region 11 may be the same or different, and a delay difference is relatively small regardless of whether the lengths are the same. Moreover/alternatively, the second trace 2b may be an initial voltage line (referring to V1 in FIG. 9), and in an initial voltage line disconnected at the hole-punch region 11, the length of a portion located on the left side of the hole-punch region 11 is the same as the length of a portion located on the right side of the hole-punch region 11, to minimize a signal delay difference.

The first trace 1a may be a signal wire D 1, and portions of the signal wire D1 located on different sides of the hole-punch region 11 are all connected by the first winding u1.

The first trace 1b may be an electroluminescent device drain voltage line E1, and portions of the electroluminescent device drain voltage line E1 located on different sides of the hole-punch region 11 may be disconnected, that is, the drain voltage line E1 is not connected by the first winding, or may be connected by the first winding. A load difference between portions of the electroluminescent device drain voltage line E1 located on different sides of the hole-punch region 11 is relatively small, and a delay difference is not obvious. To ensure that potentials between different electroluminescent devices drain voltage lines E1 are the same, different electroluminescent device drain voltage lines E1 may be connected by transverse connecting lines (1c and 1c') extending in the second direction. For details, refer to the corresponding description of the transverse connecting lines (1c and 1c') in FIG. 5.

The foregoing is merely an example. To reduce the arranged first windings, in at least a portion of the first traces whose directions pass through the hole-punch region, portions of each of the first traces respectively arranged on two sides of the hole-punch region are disconnected; and/or to reduce the arranged second windings, in at least a portion of the second traces whose extension directions pass through the hole-punch region, portions of each second trace arranged on two sides of the hole-punch region are disconnected.

It should be noted that in the foregoing, sections of traces are formed by using the first metal layer M1, the second metal layer M2, the third metal layer M3, and the fourth metal layer M4, and different traces are connected together by using vias, but this is merely an example. Alternatively, three, five, or other quantity of metal layers may be disposed, and corresponding traces are formed by patterning the metal layers.

In addition, the foregoing separately describes the first trace extending in the first direction and corresponding first winding, and the second trace extending in the second direction and corresponding second winding. It should be noted that, features of the first trace and corresponding first winding, and features of the second trace and corresponding second winding may be freely combined. For example, a specific embodiment may cover related features of the first trace and corresponding first winding, or related features of the second trace and corresponding second winding, or have features of both the foregoing aspects.

Based on a same technical concept, an embodiment of this application further provides a terminal device. The terminal device may be a terminal device having a front-facing camera, such as a mobile phone, a tablet computer, or a smartwatch.

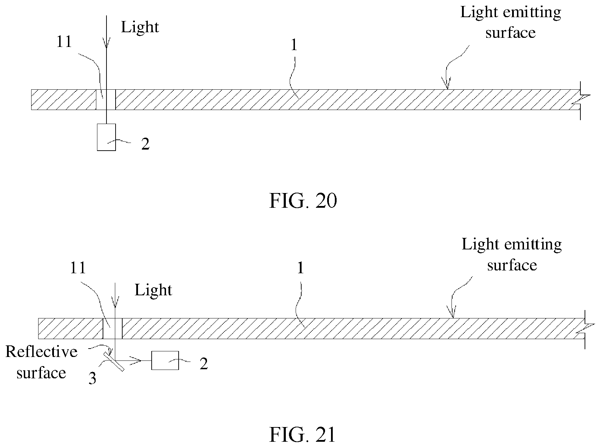

FIG. 20 is a schematic diagram of cooperation between a camera 2 and a display panel 1 in a terminal device according to an embodiment of this application. Referring to FIG. 20, the terminal device includes the camera 2 and the display panel 1 provided in the foregoing embodiment. The camera 2 is located on a side that is of the display panel 1 and that is away from a light emitting surface. In addition, a light collection window of the camera 2 is disposed opposite to a hole-punch region 11 of the display panel 1, and external ambient light is directly transmitted to the light collection window of the camera 2 through the hole-punch region 11, and is captured and imaged by the camera 2.

FIG. 21 is a schematic diagram of cooperation between a camera 2 and a display panel 1 in another terminal device according to an embodiment of this application. Referring to FIG. 21, a difference between FIG. 21 and FIG. 20 lies in that a periscope 3 is further disposed on a side that is of the display panel 1 and that is away from a light emitting surface. A reflective surface of the periscope 3 is at an acute angle, for example, 45°, with respect to a light emitting surface of the display panel 1, an optical axis of the camera 2 is, for example, parallel to the light emitting surface of the display panel 1, and the reflective surface of the periscope 3 is opposite to the hole-punch region 11 and is opposite to the light collection window of the camera 2. External ambient light is emitted to the reflective surface of the periscope 3 through the hole-punch region 11, and is reflected to the light collection window of the camera 2 through the reflective surface, to form an image in the camera 2.

The embodiments shown in FIG. 20 and FIG. 21 are merely examples, provided that the camera 2 is disposed on a side that is of the display panel 1 and that is away from the light emitting surface, and is configured to receive light passing through the hole-punch region, so as to perform imaging.

In embodiments of this application, unless otherwise specified or logically conflicted, terms and/or descriptions in the different embodiments are consistent and may be mutually referenced, and technical features in different embodiments may be combined to form a new embodiment based on internal logical relationships of the different embodiments.

In this application, and/or describes an association relationship between associated objects, and represents that three relationships may exist. For example, A and/or B may represent the following cases: Only A exists, both A and B exist, and only B exists, where A and B may be singular or plural. In this application, "parallel" may not mean absolute parallel, and "vertical" may not mean absolute vertical, and a specific engineering error may be allowed.

In addition, in this application, orientation terms such as "up" and "down" are defined relative to an orientation in which a component is schematically placed in the accompanying drawings. It should be understood that these directional terms are relative concepts, and are used for relative description and clarification, which may vary accordingly depending on the orientation in which the components are placed in the accompanying drawings.

It may be understood that various numbers in embodiments of this application are merely used for differentiation for ease of description, and are not used to limit the scope of embodiments of this application. The sequence numbers of the foregoing processes do not mean execution sequences, and the execution sequences of the processes should be determined based on functions and internal logic of the processes. The terms "first", "second", and the like are used to distinguish between similar objects, and do not need to be used to describe a specific order or sequence.

In addition, components in the accompanying drawings in the embodiments of this application are merely intended to indicate working principles of the display panel and the terminal device, and do not truly reflect an actual size relationship of the components.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A display panel, wherein the display panel is provided with an effective display region, a hole-punch region located in the effective display region, and a border region surrounding the hole-punch region;
the effective display region is provided with a plurality of first traces extending in a first direction, and second traces extending in a second direction, wherein the first direction is perpendicular to the second direction;
in at least a portion of the first traces whose extension directions pass through the hole-punch region, portions of each first trace respectively arranged on two sides of the hole-punch region are connected by one of first windings, and at least a portion of the first windings are located in the effective display region; and/or
in at least a portion of the second traces whose extension directions pass through the hole-punch region, portions of each second trace respectively arranged on two sides of the hole-punch region are connected by one of second windings, and at least a portion of the second windings are located in the effective display region.

2. The display panel according to claim 1, wherein each of the first windings comprises a first segment, a second segment, and a third segment, the first segment extends in the first direction, and both the second segment and the third segment extend in the second direction; and
in each group of the first trace and the first winding that correspond to each other, one end of the second segment is connected to a portion that is of the first trace and that is located on one side of the hole-punch region; one end of the third segment is connected to a portion that is of the first trace and that is located on the other side of the hole-punch region; and the other end of the second segment is connected to the other end of the third segment by the first segment.

3. The display panel according to claim 2, wherein in each of the first windings, the first segment, the second segment, and the third segment each are disposed hierarchically with respect to a corresponding first trace.

4. The display panel according to claim 3, wherein in each or at least a portion of the first windings, the second segment and the third segment each are disposed hierarchically with respect to the first segment.

5. The display panel according to any one of claims 2 to 4, wherein a portion of the first traces are signal wires; and
in at least a portion of the signal wires, one first segment is disposed on at least one side of the second direction of each signal wire, and/or the signal wire and one first segment are stacked.

6. The display panel according to any one of claims 1 to 5, wherein each of the second windings comprises a fourth segment, a fifth segment, and a sixth segment, the fourth segment extends in the second direction, and both the fifth segment and the sixth segment extend in the first direction; and
in each group of the second trace and the second winding that correspond to each other, one end of the fifth segment is connected to a portion that is of the second trace and that is located on one side of the hole-punch region; one end of the sixth segment is connected to a portion that is of the second trace and that is located on the other side of the hole-punch region; and the other end of the fifth segment is connected to the other end of the sixth segment by the fourth segment.

7. The display panel according to claim 6, wherein in each of the second windings, the fourth segment, the fifth segment, and the sixth segment each are disposed hierarchically with respect to a corresponding second trace.

8. The display panel according to claim 7, wherein in each of the second windings, the fifth segment and the sixth segment each are disposed hierarchically with respect to the fourth segment.

9. The display panel according to any one of claims 1 to 8, wherein
an average resistance value per unit length of the first winding is lower than an average resistance value per unit length of the corresponding first trace; and/or
an average resistance value per unit length of the second winding is lower than an average resistance value per unit length of the corresponding second trace.

10. The display panel according to any one of claims 1 to 9, wherein in the at least a portion of the first traces whose extension directions pass through the hole-punch region, the portions of each of first traces respectively arranged on the two sides of the hole-punch region are disconnected; and/or
in the at least a portion of the second traces whose extension directions pass through the hole-punch region, the portions of each second trace respectively arranged on the two sides of the hole-punch region are disconnected.

11. The display panel according to claim 10, wherein a portion of the first traces are light emitting signal wires, and two portions that are respectively arranged on the two sides of the hole-punch region and that are of a light emitting signal wire whose extension direction passes through the hole-punch region are disconnected; and/or
a portion of the first traces are scanning lines, two portions that are respectively arranged on the two sides of the hole-punch region and that are of a scanning line whose extension direction passes through the hole-punch region are disconnected, and lengths of the portions of the scanning line respectively arranged on the two sides of the hole-punch region are equal to each other; and/or
a portion of the first traces are initial voltage lines, two portions that are respectively arranged on the two sides of the hole-punch region and that are of an initial voltage line whose extension direction passes through the hole-punch region are disconnected, and lengths of the portions of the initial voltage line respectively arranged on the two sides of the hole-punch region are equal to each other.

12. The display panel according to claim 11, wherein a portion of the second traces are electroluminescent device drain voltage lines, and portions that are respectively arranged on the two sides of the hole-punch region and that are of an electroluminescent device drain voltage line whose extension direction passes through the hole-punch region are disconnected.

13. A terminal device, comprising a camera and the display panel according to any one of claims 1 to 12, wherein the camera is disposed on a side that is of the display panel and that is away from a light emitting surface, and is configured to receive light passing through the hole-punch region to perform imaging.
